# FASCICULE DE BREVET EUROPEEN

(11) **EP 3 438 681 B1**
(45) Date de publication et mention de la délivrance du brevet: **10.04.2024**
(21) Numéro de dépôt: 18174608.2
(22) Date de dépôt: 28.05.2018
(51) Int. Cl.: G01R 31/327

(54) **PROCEDE ET DISPOSITIF DE TEST DE PROTECTION ARC ELECTRIQUE ET APPAREIL ELECTRIQUE COMPORTANT UN TEL DISPOSITIF**
METHODE UND GERÄT ZUM TESTEN EINES SCHUTZES GEGEN LICHTBÖGEN UND ELEKTRISCHER APPARAT, WELCHER EIN SOLCHES GERÄT ENTHÄLT
METHOD AND DEVICE FOR TESTING ELECTRIC-ARC PROTECTION AND ELECTRICAL UNIT INCLUDING SUCH A DEVICE

(30) Priorité: 03.08.2017 FR 1757480
(43) Date de publication de la demande: 06.02.2019
(73) Titulaire: Schneider Electric Industries SAS, 92500 Rueil-Malmaison (FR)
(72) Inventeur: BERNARD, Jean-Baptiste, 38050 Grenoble (FR); HENNEQUIN, Michel, 38050 Grenoble (FR); LEGER, Eric, 38050 Grenoble (FR)
(74) Mandataire: Schneider Electric

(56) Documents cités:
- EP-A1- 1 533 880
- US-A1- 2014 379 283
- US-B1- 6 421 214

## Description

### DOMAINE TECHNIQUE

L'invention concerne un procédé de test d'un dispositif de protection contre les arcs électriques comportant une phase de test de la protection arc électrique avec des étapes d'injection d'un signal de test dans le traitement de signaux d'arc électrique et des étapes de traitement dudit signal de test.

L'invention concerne aussi un dispositif de test d'un dispositif de protection contre les arcs électriques comportant un circuit d'injection d'un signal dans le traitement de signaux d'arc électrique et une unité de traitement pour traiter des signaux de mesure et ledit signal de test.

L'invention concerne aussi un appareil de protection électrique comportant des contacts principaux, un capteur de courant sur au moins une ligne, un mécanisme d'ouverture desdits contacts principaux, et un dispositif de protection d'arc électrique connecté au capteur de courant.

### ETAT DE LA TECHNIQUE

Il est connu d'utiliser l'injection de signaux pour tester des dispositifs de protection différentielle ou de protection d'arcs électriques. Le but de ces tests est de vérifier le fonctionnement de la chaine de mesure des signaux de défaut ou de traitement de la protection. La plupart des tests consistent à envoyer un signal de défaut et à constater le déclenchement ou l'ouverture d'un appareil électrique comme dans le document US6421214.

Il arrive aussi que certains systèmes ou appareils de protection aient des tests sans déclenchement avec des signalisations. Souvent ces tests ne sont pas complets. Ils ne contrôlent qu'une trop petite partie des appareils électriques. Lorsque les appareils électriques ont des capteurs de courant de types transformateurs ou tores de mesures ces éléments de la chaine de mesure doivent aussi être testés.

Dans bien des cas, si ces éléments sont en défaut ou leurs connexions coupées, le signal de test ne passe pas ou le déclenchement ne se fait pas. Le test n'est alors plus actif. De plus, les dispositifs de test connus ne sont pas suffisant pour tester des dispositifs de protection d'arcs électriques complexes.

### EXPOSE DE L'INVENTION

L'invention a pour but un procédé et un dispositif de test pour garantir un fonctionnement correct du test d'appareils électriques de protection arcs électriques et/ou de protection différentielle.

Les caractéristiques essentielles de l'invention sont décrites dans les revendications indépendantes 1, 9 et 17. Les modes de réalisation de l'invention sont décrits dans les revendications dépendantes.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma bloc d'un appareil électrique comportant un dispositif de test selon un mode de réalisation de l'invention ;
- la figure 2 représente le branchement des enroulements d'un transformateur de courant pour un dispositif de test selon un mode de réalisation l'invention ;
- les figures 3A à 3D représentent des chronogrammes de signaux dans un dispositif et un procédé de test selon des modes de réalisation de l'invention ;
- la figure 4 représente un premier organigramme de test de la fonction protection d'arc d'un procédé selon un mode de réalisation de l'invention ;
- la figure 5 représente un second organigramme de test de la fonction protection différentielle d'un procédé selon un mode de réalisation de l'invention ;
- la figure 6 représente un troisième organigramme détaillé de test de la fonction protection d'arc d'un procédé selon un mode de réalisation de l'invention.

### DESCRIPTION DETAILLEE DE MODES DE REALISATION

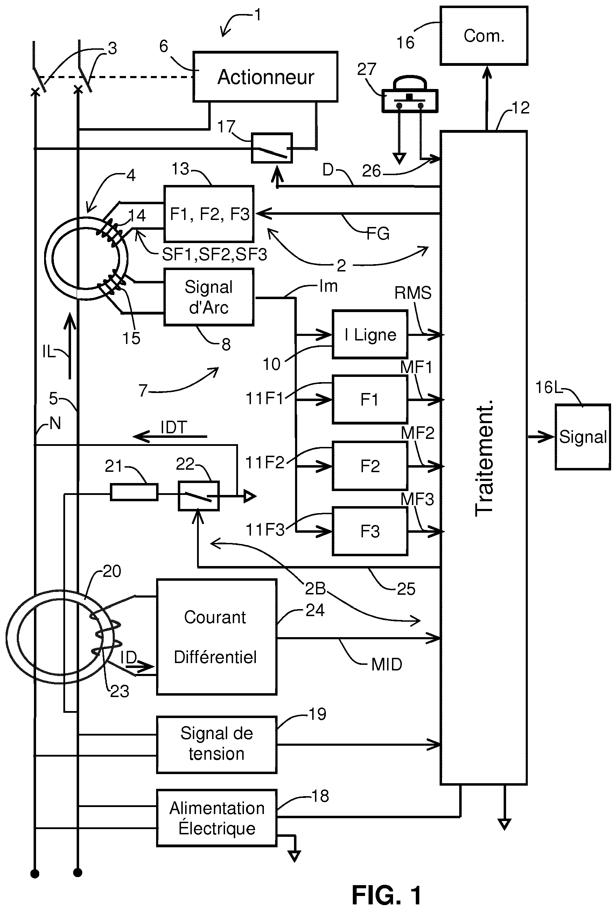

La figure 1 représente un schéma bloc d'un appareil électrique 1 comportant un dispositif de test 2 d'un dispositif de protection contre les arcs électriques. Ledit appareil de protection électrique comportant des contacts principaux 3, un capteur de courant 4 sur au moins une ligne 5 de courant de ligne, un mécanisme 6 d'ouverture desdits contacts principaux 3, et un dispositif de protection d'arc électrique connecté au capteur de courant. Le capteur de signal 4 fournit un signal de mesure représentatif d'un courant de ligne IL a un circuit 8 de conditionnement ou d'adaptation. Le circuit 8 fournit alors un signal lm de mesure à un module 10 de traitement du signal complet et à des filtres passe bande 11 F1, 11 F2 et 11F3. Une unité de traitement reçoit des signaux traités par le module 10 et des filtres 11F1, 11F2 et 11F3. Le traitement du signal complet peut consister notamment à fournir un signal RMS en valeur efficace. Les sorties des filtres fournissent des signaux dans des bandes de fréquences F1, F2 et F3. Un exemple de traitement de signaux de défaut d'arc électrique à trois fréquences est décrit dans la demande de brevet EP2816363.

Le dispositif de test 2 d'un dispositif de protection contre les arcs électriques comporte un circuit d'injection de signaux de test dans le traitement de signaux d'arcs électriques et une unité de traitement 12 pour traiter des signaux de mesure et ledit signal de test. Selon un mode de réalisation de l'invention, le dispositif de test 2 comporte :
- un générateur 13 pour générer au moins un signal de test à au moins une fréquence, ledit au moins un signal de test étant destiné à être injecté dans un bobinage 14 de test d'un transformateur 4 de mesure de courant pendant au moins une durée prédéterminée, une durée totale de test comprenant au moins la durée prédéterminée étant inférieure à un temps de non déclenchement, et
- au moins un filtre passe bande laissant passer des signaux de mesure à ladite au moins une fréquence ayant une entrée pour recevoir un signal de mesure fournit par d'un bobinage de mesure du transformateur de mesure et une sortie connectée à l'unité de traitement.

L'unité de traitement comporte des entrées connectées audit au moins un filtre pour détecter et traiter pendant l'injection dudit au moins un signal de test au moins un signal en sortie dudit au moins un filtre, et des modules de détermination de l'état du test de la protection arc électrique, l'état du test de la protection arc électrique étant négatif si aucun signal de test n'est traité correctement par la chaine de mesure.

Selon un mode de réalisation de l'invention préférentiel, le dispositif de test 2 comporte :
- un générateur 13 pour générer un premier signal de test SF1 à une première fréquence F1, ledit premier signal de test SF1 étant injecté dans un bobinage 14 de test d'un transformateur de mesure de courant pendant une première durée prédéterminée TF1, et pour générer un second signal de test SF2 à une seconde fréquence F2, ledit second signal de test SF2 étant injecté dans ledit bobinage de test dudit transformateur de mesure de courant pendant une seconde durée prédéterminée TF2, une durée totale TT de test comprenant au moins la première et la seconde durée T1 et T2 étant inférieure à un temps TND de non déclenchement,
- un premier filtre 11F1 passe bande laissant passer des signaux représentatifs des signaux de mesure ou de test MF1 à la première fréquence F1 ayant une entrée pour recevoir un signal Im représentatif d'un signal fournit par d'un bobinage de mesure 15 dudit transformateur et une sortie connectée à l'unité de traitement, et
- un second filtre 11F2 passe bande laissant passer des signaux Im représentatifs des signaux de mesure ou de test MF2 à la seconde fréquence F2 ayant une entrée pour recevoir un signal de mesure Im représentatif d'un signal fournit par ledit bobinage de mesure dudit transformateur et une sortie connectée à l'unité de traitement. Dans le mode de réalisation de la figure 1, le générateur 13 reçoit un signal de commande FG pour commander périodiquement la génération de signaux.

L'unité de traitement 12 comporte des entrées connectées audits premier 11F1 et second 11F2 filtres pour détecter et traiter pendant les injections du premier SF1 et du second SF2 signal de test les signaux MF1 et MF2 en sortie desdits filtres, et des modules de détermination de l'état du test de la protection arcs électriques. L'état du test de la protection arc électrique est négatif si aucun signal de test SF1 ou SF2 n'est traité correctement par la chaine de mesure. Si les résultats de test sont négatifs, l'unité de traitement peut déclencher l'ouverture des contacts 3 en fournissant un signal de commande D commandant l'actionneur 6 à travers un interrupteur commandé 17.

L'unité de traitement est alimentée pour son fonctionnement par un circuit d'alimentation connecté de préférence aux lignes 5 et N. Pour certaines fonctions supplémentaires, un circuit de mesure de tension 19 fournit à l'unité de traitement un signal de mesure d'une tension représentatif d'une tension électrique présente sur les lignes 5 et N.

Dans un dispositif de test pour un dispositif de protection arc électrique à trois fréquences, ledit générateur 13 génère un troisième signal de test SF3 à une troisième fréquence F3, ledit troisième signal de test SF3 étant injecté dans ledit bobinage de test dudit transformateur de mesure de courant pendant une troisième durée prédéterminée T3, une durée totale de test TT comprenant au moins la première, la seconde et la troisième durées T1, T2 et T3 étant inférieure à un temps de non déclenchement TND. Le dispositif de protection d'arcs électriques comporte aussi un troisième filtre passe bande 11F3 laissant passer des signaux de mesure ou de test MF3 à la troisième fréquence F3. Le filtre 11F3 comporte une entrée pour recevoir un signal Im fournit par ledit bobinage de mesure du transformateur et une sortie connectée à l'unité de traitement. Dans ce cas, l'unité de traitement comporte des entrées connectées audits premier, second et troisième filtres 11F1, 11F2 et 11F3 pour détecter et traiter pendant les injections du premier, du second et du troisième signal de test SF1, SF2 et SF3 les signaux MF1, MF2 et MF3 fournis par les filtres F1, F2 et F3. Dans cette configuration, des modules de détermination de l'état du test de la protection arcs électriques indiquent que l'état du test de la protection arc électrique est négatif si aucun signal de test n'est traité correctement par la chaine de mesure.

Dans le mode de réalisation de la figure 1, l'unité de traitement comporte aussi une entrée de ligne pour détecter et traiter pendant les injections du premier, du second et du troisième signal de test SF1, SF2 et SF3, les signaux fournis par les filtres MF1, MF2 et MF3 et aussi un signal RMS de ligne Im passant par le module 10 de traitement du signal complet. Dans des modules de détermination de l'état du test de la protection arc électrique, l'état du test de la protection arc électrique est négatif si aucun signal de test SF1, SF2 et SF3 n'est traité correctement par la chaine de mesure, ou si un seul signal de test parmi les trois est traité correctement par la chaine de mesure et que ledit signal de ligne Im est inférieur à un seuil prédéterminé Slm. Le module 10 de traitement du signal complet fournit par exemple un signal RMS de type valeur efficace du signal lm.

Les résultats de test sont de préférence fournis à un circuit de communication 16 connecté à l'unité de traitement 12 et/ou à un dispositif de signalisation locale 16L.

Le dispositif de test 2 d'un dispositif de protection contre les arcs électriques peut aussi être combiné avec un dispositif 2B de test de la protection différentielle. Ladite protection différentielle comporte un capteur 20 de mesure différentielle entourant l'ensemble des conducteurs de lignes, dans le cas de la figure 1, un conducteur de phase 5 et un conducteur de neutre N. Pour effectuer le test de la fonction différentielle, un circuit fait circuler un courant de test entre l'amont et l'aval du capteur 20 tel qu'un tore de mesure. Ainsi, le courant de test passe à l'intérieur du tore dans un sens et à l'extérieur du tore dans un autre sens. Le tore de mesure étant un transformateur de courant, il comporte aussi un enroulement de test pour faire circuler un courant de test. Sur la figure 1, le circuit de test comprend une résistance 21 connectée en aval du capteur 20 sur le conducteur de phase 5 et en amont sur le conducteur de neutre à travers un interrupteur commandé 22. Le capteur 20 est de préférence un transformateur de courant en forme de tore entourant les conducteurs principaux de ligne notamment un conducteur de phase 5 et un conducteur de neutre sur la figure 1. Le transformateur 20 comporte aussi un enroulement secondaire 23 connecté à un circuit 24 d'adaptation pour recevoir un courant de mesure ID différentiel et pour fournir un signal MID de mesure différentielle à l'unité de traitement 12. Dans d'autres modes de réalisation, le test de la fonction différentielle peut aussi se faire en injectant un signal de test dans un bobinage de test supplémentaire enroulé sur le transformateur 20.

Dans un mode de réalisation de l'invention, l'unité de traitement comporte :
- une sortie de commande 25 de test d'une chaine de traitement de protection différentielle pour commander pendant une durée T4 inférieure à une durée de non déclenchement différentiel TNDdiff la circulation d'un courant différentiel de test IDT entre l'amont et l'aval d'un transformateur 20 de mesure de courant différentiel ID,
- des modules de détermination de l'état du test de la protection différentielle, et
- des modules de détermination de l'état global du test indiquant un test négatif si le test de la protection différentielle est en défaut ou si les modules de détermination de l'état du test de la protection arc électrique indiquent un test négatif.

Si les résultats de test sont négatifs, l'unité de traitement peut déclencher l'ouverture des contacts 3 en fournissant un signal de commande D commandant l'actionneur 6 à travers un interrupteur commandé 17.

De préférence, l'unité de traitement commande les tests de la protection arc électrique et/ou de la protection différentielle sans déclenchement ou ouverture de l'appareil de manière automatique à intervalles de temps prédéterminés. Ces intervalles peuvent être, par exemple, de plusieurs heures ou d'une journée.

Des tests avec déclenchement peuvent aussi être faits de manière manuelle. Ainsi, l'unité de traitement comporte une entrée 26 connectée à un élément de commande 27 de test pour commander le test de manière manuelle. Une durée TM d'injection de signaux de test étant alors supérieure à des temps de déclenchement TD. L'élément de commande 27 peut être par exemple un bouton poussoir de test pouvant être manoeuvré par un utilisateur et accessible sur la face avant d'un appareil électrique.

L'unité de traitement comporte une sortie D de déclenchement de l'ouverture d'un appareil électrique si le test de la protection différentielle est en défaut ou si l'état du test de la protection arc électrique indique un test négatif, ou si l'élément de test commande 27 le test de manière manuelle.

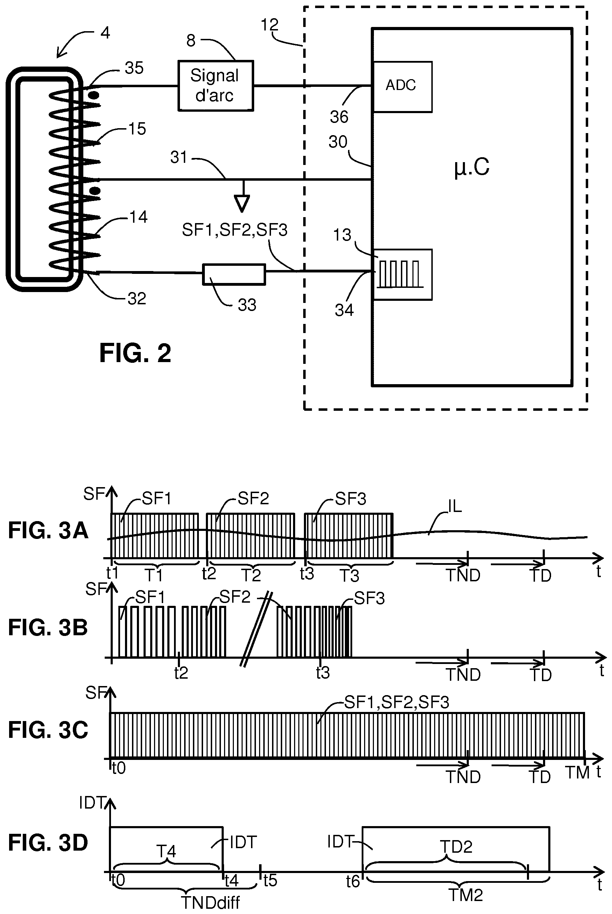

La figure 2 représente le branchement des bobinages d'un transformateur de courant pour un dispositif de test selon un second mode de réalisation de l'invention. L'unité centrale comporte un microcontrôleur ou un microprocesseur 30 ayant des entrées connectées aux enroulements du transformateur 4. Pour simplifier les liaisons une extrémité de chaque bobinage 14 et 15 est reliée à une ligne commune 31 qui peut être aussi une ligne de référence connectée au microcontrôleur 30. Une autre extrémité 32 du bobinage 14 de test du transformateur de mesure de courant est connectée à travers une résistance 33 à une sortie 34 du microcontrôleur 30 pour recevoir les signaux de test SF1, SF2, SF3. Ainsi, le générateur 13 est de préférence intégré sous forme numérique dans un module ou une partie de programme du microcontrôleur. La sortie 34 est de préférence une sortie numérique tout-ou-rien de type TOR. Dans d'autres modes de réalisation une telle sortie 34 peut aussi être à modulation de largeur d'impulsion. Une autre extrémité 35 du bobinage de mesure 15 dudit transformateur 4 est reliée à une entrée 36 du microcontrôleur 30 à travers le circuit 8 de conditionnement ou d'adaptation pour fournir un signal de mesure Im pour le traitement. Dans ce cas, le circuit 8 de conditionnement ou d'adaptation est relié à un convertisseur analogique-numérique. Le signal Im sera alors numérique et le module 10 de traitement du signal complet et les filtres passe bande 11F1, 11F2 et 11F3 seront également numériques et traités par le microcontrôleur ou des processeurs ou modules dédiés à ces fonctions.

Les signaux de test SF1, SF2, SF3 ont des fréquences différentes caractéristiques des signaux d'arc hautes fréquences ou des harmoniques à détecter. Par exemple, la fréquence F1 du signal SF1 est de préférence de 20 kHz, la fréquence F2 du signal SF2 est de préférence de 30 kHz, et la fréquence F3 du signal SF3 est de préférence de 50 kHz. En fonction du type de défaut d'arc électrique à détecter ces fréquences peuvent être différentes. Il en va de même des filtres 11F1, 11F2 et 11F3 ainsi que de leurs bandes passantes.

Les figures 3A à 3D représentent des chronogrammes de signaux dans un dispositif et un procédé de test selon des modes de réalisation de l'invention. Sur la figure 3A, à un instant t1 un signal de test SF1 à une première fréquence F1 est généré pendant une période T1, puis à un instant t2 un signal de test SF2 à une seconde fréquence F2 est généré pendant une période T2, puis à un instant t3 un signal de test SF3 à une troisième fréquence F3 est généré pendant une période T3. Entre le début de la première période T1 et la fin de la troisième période T3, la durée de d'injection des signaux de test est inférieure à un temps de non déclenchement TND. Ce temps TND correspond à un temps maximum pendant lequel un signal de défaut peut être présent sans provoquer de déclenchement. Sur la figure 3B les signaux de test SF1, SF2, SF3 sont injectés comme un seul signal avec des changements de fréquence au instants t2 et t3. La durée totale est aussi inférieure au temps de non déclenchement TND.

La figure 3C montre des signaux de test SF1, SF2, SF3 injectés pendant une période TM supérieure au temps de déclenchement TD. Le temps de déclenchement TD correspond à une durée de défaut maximale pour un déclenchement certain. Le temps TM est nettement supérieur au temps de non déclenchement TND. Dans ce cas l'injection est commandée notamment par une action sur l'élément de commande 27.

La figure 3D représente un chronogramme du test de la fonction différentielle. Pendant une période T4 entre un instant t0 et un instant t4, un défaut différentiel IDT est simulé en dérivant un courant à l'extérieur du transformateur 20. Cette commande est générée par l'unité de traitement sur l'interrupteur commandé 22. La période T4 est inférieure à un temps de non déclenchement différentiel TNDdiff qui expire à l'instant t5. A l'instant t6, une autre signal IDT est généré ou simulé dans le transformateur 20. Ce signal dure pendant une durée TM2 supérieure au temps de déclenchement différentiel TD2.

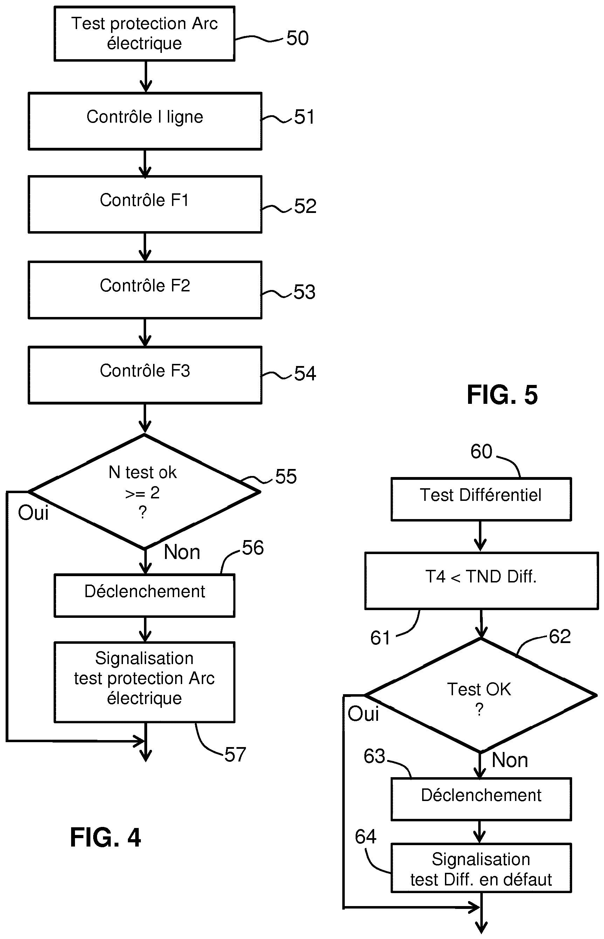

La figure 4 représente un premier organigramme de test de la fonction de protection d'arc électrique d'un procédé selon un mode de réalisation de l'invention. Le procédé de test d'un dispositif de protection contre les arcs électriques comporte une phase de test de la protection arc électrique avec des étapes d'injection d'un signal dans le traitement de signaux d'arc électrique et des étapes de traitement dudit signal de test.

A une étape 50 le test de la protection arc électrique est lancée. Le lancement de cette étape est très espacé, de l'ordre de 10 heures ou plus. Dans ce mode de réalisation, une étape 51 contrôle aussi la présence d'un courant de ligne.

Généralement ce courant de ligne est traité en valeur efficace RMS. Le courant de ligne peut aussi être un signal de test quel que soit sa fréquence.

Le procédé de test comporte :
- au moins une étape d'injection d'au moins un signal de test à au moins une fréquence dans un bobinage 14 de test d'un transformateur 4 de mesure de courant pendant au moins une durée prédéterminée, une durée totale de test comprenant au moins la durée prédéterminée étant inférieure à un temps de non déclenchement TND,
- au moins une étape de contrôle pour contrôler pendant l'injection dudit au moins un signal au moins un signal de test filtré et traité par une chaine de mesure et/ou des fonctions de protection, et
- une étape de détermination de l'état du test de la protection arc électrique, l'état du test de la protection arc électrique étant négatif si aucun signal de test n'est traité correctement par la chaine de mesure.

Une première étape 52 contrôle le test à une première fréquence F1. Dans cette étape, il y a l'injection d'un premier signal de test SF1 à une première fréquence F1 dans un bobinage 14 de test d'un transformateur de mesure 4 de courant pendant une première durée prédéterminée T1. Une seconde étape 53 contrôle le test à une seconde fréquence F2. Dans cette étape, il y a l'injection d'un second signal de test SF2 à une seconde fréquence F2 dans un bobinage 14 de test du transformateur de mesure 4 de courant pendant une seconde durée prédéterminée T2.

Pendant les injections du premier et du second signal de test, une étape de traitement associée aux étapes de contrôle 51 et 52 détecte des signaux de tests filtrés et traités par une chaine de mesure et/ou des fonctions de protection. Ainsi, une étape de détermination de l'état du test de la protection arc électrique indique que l'état du test de la protection arc électrique est négatif si aucun signal de test n'est traité correctement par la chaine de mesure.

Pendant la phase de test de la figure 4, une troisième étape 54 contrôle le test à une troisième fréquence F3. Dans cette étape, il y a l'injection d'un troisième signal de test SF3 à une troisième fréquence F3 dans un bobinage 14 de test du transformateur de mesure 4 de courant pendant une troisième durée prédéterminée T3. La durée totale de test, comprenant au moins la première, la seconde et la troisième durées, respectivement T1, T2 et T3, est inférieure à un temps de non déclenchement TND.

Une étape de traitement associée aux étapes de contrôle 51, 52 et 53 détecte des signaux de tests filtrés et traités par une chaine de mesure et/ou des fonctions de protection. Puis une étape 55 de détermination de l'état du test de la protection arc électrique indique que l'état du test de la protection arc électrique est négatif si aucun signal de test n'est traité correctement par la chaine de mesure.

Dans le mode de réalisation de la figure 4, l'étape 51 contrôle aussi le signal de ligne, ce contrôle peut être notamment un contrôle de seuil du signal de ligne. Ce signal dit de ligne est en fait un signal non filtré par les filtres d'identification du défaut d'arc électrique spécifique. Ainsi ce test détecte la chaine de traitement hors filtrage. Si le signal est inférieur à un seuil cette chaine peut être considérée en défaut. Dans ce mode de réalisation, l'étape 55 détermine si le test est en défaut en fonction du nombre de test positifs ou négatifs pendant la phase de test. Puisque le nombre de tests est de quatre, l'étape détermine un test global positif si au moins 2 tests sont positifs. Ainsi, l'étape de détermination 55 de l'état du test de la protection arc électrique indique un test négatif :
si aucun signal de test SF1, SF2, SF3 n'est traité correctement par la chaine de mesure, ou
si un seul signal de test parmi les trois SF1, SF2, SF3 est traité correctement par la chaine de mesure et que ledit signal de ligne IM ou RMS est inférieur à un seuil prédéterminé.

Si le test est négatif, une étape 56 de déclenchement commande l'ouverture de l'appareil électrique. Une étape 57 commande aussi la signalisation d'un défaut du test de la fonction protection arcs électriques.

La figure 5 représente un organigramme de test de la fonction protection différentielle d'un procédé selon un mode de réalisation de l'invention. A une étape 50 le test de la protection différentielle est lancée. Le lancement de cette étape peut être fait dans un même cycle de test que celui de la fonction arc électrique. Puis, à une étape 61 de test d'une chaine de traitement de protection différentielle l'unité de traitement commande la circulation d'un courant différentiel IDT entre l'amont et l'aval du transformateur 20 de mesure de courant différentiel ID pendant une période T4. Une étape de détermination 62 de l'état du test indique un test négatif si l'étape de test de la protection différentielle est en défaut. Par exemple le test est en défaut si le signal différentiel est en dessous d'un seuil lors de la simulation d'un courant différentiel ID pendant une période Tldiff ou T4 inférieure à un temps de non déclenchement différentiel TNDdiff.

Lorsque les protections arc électrique et différentielle sont associées, un test est indiqué comme négatif si une l'étape de test de la protection différentielle est en défaut ou si ladite étape de détermination de l'état du test de la protection arc électrique indique aussi un test négatif. Dans les deux cas, il y a une commande de l'ouverture de l'appareil électrique et la signalisation d'un défaut du test.

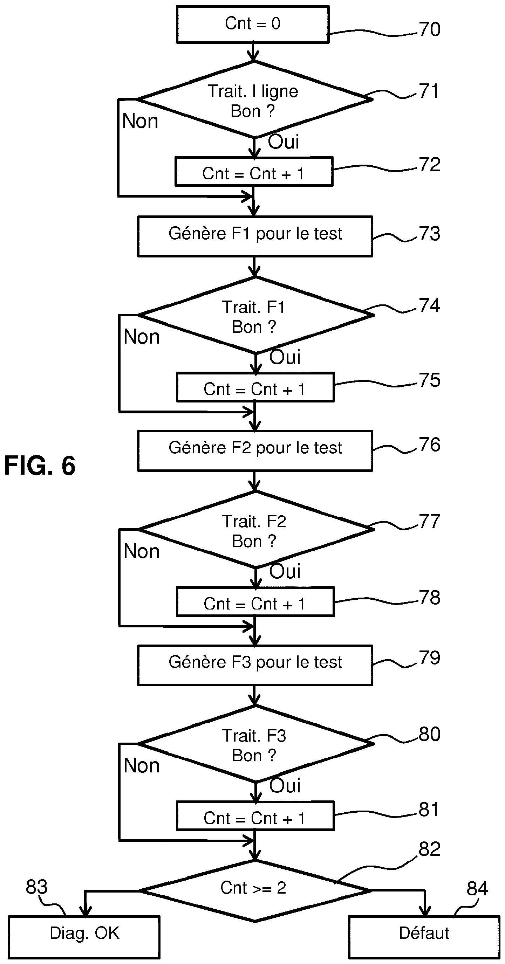

La figure 6 représente un troisième organigramme détaillé de test de la fonction protection d'arc électrique d'un procédé selon un mode de réalisation de l'invention. Cet organigramme est basé sur l'utilisation d'un compteur Cnt incrémenté à chaque étape de la fonction test de la protection arc électrique.

A une étape 70, le compteur Cnt est initialisé à une valeur 0. Puis, à une étape 71 le traitement du courant de mesure l ligne est vérifié. Si le traitement du courant de ligne est bon, le compteur Cnt est incrémenté à une valeur 1 à une étape 72 sinon il est laissé à 0. A une étape 73, un premier signal SF1 à une première fréquence F1 est généré et injecté dans le bobinage de test 14 du transformateur 4. Une étape 74 vérifie que le signal SF1 à la première fréquence F1 est traité correctement. Si le traitement du signal de test SF1 est bon, à une étape 75, le compteur Cnt est incrémenté d'une valeur prédéfinie, de préférence 1, sinon le compteur Cnt ne change pas, il garde la valeur précédente. A une étape 76, un second signal SF2 à une seconde fréquence F2 est généré et injecté dans le bobinage de test 14 du transformateur 4. Une étape 77 vérifie que le signal SF2 à la seconde fréquence F2 est traité correctement. Si le traitement du signal de test SF2 est bon, à une étape 78 le compteur Cnt est incrémenté d'une valeur prédéfinie, de préférence 1, sinon le compteur Cnt ne change pas, il garde la valeur précédente. A une étape 79, un troisième signal SF3 à une troisième fréquence F3 est généré et injecté dans le bobinage de test 14 du transformateur 4. Une étape 80 vérifie que le signal SF3 à la troisième fréquence F3 est traité correctement. Si le traitement du signal de test SF3 est bon, à une étape 81, le compteur Cnt est incrémenté d'une valeur prédéfinie, de préférence 1, sinon le compteur Cnt ne change pas, il garde la valeur précédente. En fin de test, une étape 82 permet de déterminé l'état du test en fonction de la valeur du compteur Cnt. Si la valeur du compteur représente au moins deux test positifs, soit une valeur supérieure ou égale à deux dans le cas de la figure 6, le diagnostic est bon. Une étape 83 signale un test correct. Si à l'étape 82, le compteur représente un nombre de test valable inférieur à deux, soit 0 ou 1, une étape 84 déclenche le processus de test en défaut avec notamment le déclenchement de l'ouverture de l'appareil.

Dans le procédé aussi, la phase de test est déclenchée, sans déclenchement ou ouverture de l'appareil, de manière automatique à intervalles de temps prédéterminé, par exemple de plusieurs heures ou d'une journée.

La phase de test du procédé peut être déclenchée aussi de manière manuelle au moyen d'un élément de commande de test, la durée d'injection de signaux de test étant supérieure à des temps de déclenchement.

Ainsi, dans le procédé, la phase de test comporte une étape de déclenchement de l'ouverture d'un appareil électrique si l'étape de test de la protection différentielle est en défaut, si ladite étape de détermination de l'état du test de la protection arc électrique indique un test négatif ou si la phase de test est déclenchée de manière manuelle.

L'unité de traitement comporte une sortie D de déclenchement de l'ouverture d'un appareil électrique si le test de la protection différentielle est en défaut ou si l'état du test de la protection arc électrique indique un test négatif, ou si l'élément de test commande 27 le test de manière manuelle.

Le nombre de fréquences utilisées pour le test de la fonction de protection arc électrique est de préférence de trois mais d'autre valeurs sont possibles, par exemple une pour un fonctionnement minimal ou deux, trois, quatre et plus pour un fonctionnement plus précis. Le nombre de fréquences des signaux de test est de préférence égal au nombre de filtres passe-bande. Cependant, il est possible que le nombre de fréquences soit différent.

L'appareil électrique représenté sur la figure 1 est un appareil bipolaire avec deux lignes phase et neutre avec une protection de l'arc électrique sur une phase. Cependant, l'invention s'applique aussi à des appareils bipolaires ou tripolaires avec une protection d'arcs électriques deux ou plusieurs lignes. Les signaux de test sont alors injectés sur deux ou plusieurs transformateurs de mesure d'arc électriques.

## Revendications

1. Procédé de test d'un dispositif de protection contre les arcs électriques, le dispositif de protection contre les arcs électriques comportant une chaîne de mesure, la chaine de mesure comportant un premier bobinage (15) de mesure d'un transformateur (4) de mesure de courant, le procédé de test comportant une phase de test de la protection arc électrique avec des étapes d'injection d'un signal de test dans le traitement de signaux d'arc électrique et des étapes de traitement dudit signal de test,
comportant:
- au moins une étape d'injection d'au moins un signal de test (SF1, SF2, SF3) à au moins une fréquence (F1, F2, F3) dans un deuxième bobinage (14) de test du transformateur (4) de mesure de courant pendant au moins une durée (T1, T2, T3) prédéterminée, une durée totale de test comprenant au moins la durée prédéterminée (T1, T2, T3) étant inférieure à un temps de non déclenchement (TND)
- au moins une étape (52, 53, 54, 71, 74, 77) de contrôle pour contrôler pendant l'injection dudit au moins un signal (SF1, SF2, SF3) au moins un signal de test filtré et traité par la chaine de mesure et/ou des fonctions de protection, et
- une étape (55) de détermination de l'état du test de la protection arc électrique, l'état du test de la protection arc électrique étant négatif si aucun signal de test n'est traité correctement par la chaine de mesure.

2. Procédé de test selon la revendication 1 **caractérisé en ce qu'**il comporte pendant la phase de test :
- une première étape (52, 73) d'injection d'un premier signal (SF1) de test à une première fréquence (F1) dans le deuxième bobinage (14) de test du transformateur (4) de mesure de courant pendant une première durée (T1) prédéterminée,
- une seconde étape (53, 76) d'injection d'un second signal (SF2) de test à une seconde fréquence (F2) dans ledit deuxième bobinage (14) de test dudit transformateur (4) de mesure de courant pendant une seconde durée (T2) prédéterminée, une durée totale de test comprenant au moins la première et la seconde durée (T1 et T2) étant inférieure à un temps de non déclenchement (TND),
- des étapes (52, 53, 54, 71, 74, 77) de contrôle pour contrôler pendant les injections du premier et du second signal (SF1, SF2,) de test des signaux de tests filtrés et traités par une chaine de mesure et/ou des fonctions de protection, et
- ladite étape (55) de détermination de l'état du test de la protection arc électrique, l'état du test de la protection arc électrique étant négatif si aucun signal de test n'est traité correctement par la chaine de mesure.

3. Procédé de test selon la revendication 2 **caractérisé en ce qu'**il comporte pendant la phase de test :
- une troisième étape (54, 79) d'injection d'un troisième signal (SF3) de test à une troisième fréquence (F3) dans ledit deuxième bobinage (14) de test dudit transformateur (4) de mesure de courant pendant une troisième durée (T3) prédéterminée, la durée totale de test, comprenant au moins la première, la seconde et la troisième durées (T1, T2 et T3), étant inférieure à un temps de non déclenchement (TND),
- des étapes (52, 53, 54, 74, 77, 80) de contrôle pour contrôler pendant les injections du premier, du second et du troisième signal (SF1, SF2, SF3) de test des signaux de tests filtrés et traités par une chaine de mesure et/ou des fonctions de protection, et
- ladite étape de détermination (55, 82) de l'état du test de la protection arc électrique, l'état du test de la protection arc électrique étant négatif si aucun signal de test n'est traité correctement par la chaine de mesure.

4. Procédé de test selon l'une des revendications 2 ou 3 **caractérisé en ce que** qu'il comporte une étape de contrôle (51 et 71) pendant ladite phase de test pour contrôler la présence d'un signal de ligne (I ligne),
ladite étape de détermination de l'état du test de la protection arc électrique indique un test négatif :
- si aucun signal de test n'est traité correctement par la chaine de mesure, ou
- si un seul signal de test est traité correctement par la chaine de mesure et que ledit signal de ligne est inférieur à un seuil prédéterminé.

5. Procédé de test selon l'une quelconque des revendications 1 à 4 **caractérisé en ce que** la phase de test comporte une étape (60-64) de test d'une chaine de traitement de protection différentielle en commandant la circulation d'un courant différentiel (IDT) entre l'amont et l'aval d'un transformateur (20) de mesure de courant différentiel (ID),
une étape de détermination (55, 82, 62) de l'état du test commune indique un test négatif si l'étape de test de la protection différentielle (60-64) est en défaut, ou si ladite étape de détermination de l'état du test de la protection arc électrique indique un test négatif.

6. Procédé de test selon l'une quelconque des revendications 1 à 5 **caractérisé en ce que** la phase de test est déclenchée de manière automatique à intervalles de temps prédéterminés.

7. Procédé de test selon l'une quelconque des revendications 1 à 6 **caractérisé en ce que** la phase de test est déclenchée de manière manuelle au moyen d'un élément de commande de test, la durée (TM) d'injection de signaux de test étant supérieure à des temps de déclenchement (TD).

8. Procédé de test selon l'une quelconque des revendications 1 à 7 **caractérisé en ce que** la phase de test comporte une étape de déclenchement de l'ouverture d'un appareil électrique si l'étape de test de la protection différentielle est en défaut, si ladite étape de détermination de l'état du test de la protection arc électrique indique un test négatif ou si la phase de test est déclenchée de manière manuelle.

9. Dispositif de test (2) d'un dispositif de protection contre les arcs électriques, le dispositif de protection contre les arcs électriques comportant une chaîne de mesure, la chaine de mesure comportant un premier bobinage (15) de mesure d'un transformateur (4) de mesure de courant, le dispositif de test (2) comportant un circuit d'injection d'un signal dans le traitement de signaux d'arc électrique et une unité de traitement (12) pour traiter des signaux de mesure et ledit signal de test,
comportant:
- un générateur pour générer au moins un signal (SF1, SF2, SF3) de test à au moins une fréquence (F1, F2, F3), ledit au moins un signal de test étant destiné à être injecté dans un deuxième bobinage (14) de test du transformateur (4) de mesure de courant pendant au moins une durée (T1, T2, T3) prédéterminée, une durée totale de test comprenant au moins la durée prédéterminée (T1, T2, T3) étant inférieure à un temps de non déclenchement (TND), et
- au moins un filtre (11F1, 11F2, 11F3) passe bande laissant passer des signaux de mesure à ladite au moins une fréquence (F1, F2, F3) ayant une entrée pour recevoir un signal de mesure (Im) fournit par le bobinage (15) de mesure du transformateur (4) de mesure et une sortie connectée à l'unité de traitement,
l'unité de traitement comportant :
- des entrées connectées audit au moins un filtre pour détecter et traiter pendant l'injection dudit au moins un signal de test (SF1, SF2, SF3) au moins un signal en sortie dudit au moins un filtre (11F1, 11F2, 11F3), et
- des modules de détermination de l'état du test de la protection arc électrique, l'état du test de la protection arc électrique étant négatif si aucun signal de test (SF1, SF2, SF3) n'est traité correctement par la chaine de mesure.

10. Dispositif de test selon la revendication 9 **caractérisé en ce que** :
- ledit générateur (13) génère :
- un premier signal (SF1) de test à une première fréquence (F1), ledit premier signal de test étant destiné à être injecté dans le deuxième bobinage (14) de test d'un transformateur (4) de mesure de courant pendant une première durée (T1) prédéterminée, et
- un second signal (SF2) de test à une seconde fréquence (F2), ledit second signal de test étant destiné à être injecté dans ledit deuxième bobinage (14) de test dudit transformateur (4) de mesure de courant pendant une seconde durée (T2) prédéterminée, une durée totale de test comprenant au moins la première et la seconde durée (T1 et T2) étant inférieure à un temps de non déclenchement (TND), et
- le au moins un filtre comporte :
- un premier filtre (11F1) passe bande laissant passer des signaux de mesure à ladite première fréquence (F1) ayant une entrée pour recevoir un signal de mesure (Im) fournit par le premier bobinage (15) de mesure du transformateur (4) de mesure et une sortie connectée à l'unité de traitement, et
- un second filtre (11F2) passe bande laissant passer des signaux de mesure à ladite seconde fréquence (F2) ayant une entrée pour recevoir ledit signal de mesure (Im) fournit par ledit premier bobinage (15) de mesure du transformateur (4) de mesure et une sortie connectée à l'unité de traitement,
l'unité de traitement comportant :
- des entrées connectées audits premier et second filtres pour détecter et traiter pendant les injections du premier et du second signal de test (SF1, SF2) les signaux en sortie desdits filtres (11F1, 11F2), et
- des modules de détermination de l'état du test de la protection arc électrique, l'état du test de la protection arc électrique étant négatif si aucun signal de test (SF1, SF2) n'est traité correctement par la chaine de mesure.

11. Dispositif de test selon la revendication 10 **caractérisé :**
- **en ce que** ledit générateur (13) génère un troisième signal (SF3) de test à une troisième fréquence (F3), ledit troisième signal de test étant destiné à être injecté dans ledit deuxième bobinage (14) de test dudit transformateur (4) de mesure de courant pendant une troisième durée (T3) prédéterminée, une durée totale de test comprenant au moins la première, la seconde et la troisième durées (T1, T2 et T3) étant inférieure à un temps de déclenchement (TND), et
- **en ce qu'**il comporte un troisième filtre (11F3) passe bande laissant passer des signaux de mesure à la troisième fréquence (F3) ayant une entrée pour recevoir un signal de mesure (Im) fournit par ledit premier bobinage (15) de mesure du transformateur (4) de mesure et une sortie connectée à l'unité de traitement, l'unité de traitement comportant :
- des entrées connectées audit premier, second et troisième filtres (11F1, 11F2, 11F3) pour détecter et traiter pendant les injections du premier, du second et du troisième signal de test (SF1, SF2, SF3), les signaux fournis par les filtres, et
- des modules de détermination de l'état du test de la protection arc électrique, l'état du test de la protection arc électrique étant négatif si aucun signal de test n'est traité correctement par la chaine de mesure.

12. Dispositif de test selon l'une quelconque des revendications 9 à 11 **caractérisé en ce que** l'unité de traitement comporte aussi :
- une entrée de ligne pour détecter et traiter pendant les injections du au moins un signal (SF1, SF2, SF3) de test, les signaux fournis par ledit au moins un filtre (11F1, 11F2, 11F3) et un signal de ligne (lm, 10), et
- des modules de détermination de l'état du test de la protection arc électrique, l'état du test de la protection arc électrique étant négatif si aucun signal de test n'est traité correctement par la chaine de mesure, ou si un seul signal de test parmi trois est traité correctement par la chaine de mesure et que ledit signal de ligne est inférieur à un seuil prédéterminé.

13. Dispositif de test selon l'une quelconque des revendications 9 à 12 **caractérisé en ce que** l'unité de traitement comporte (12) :
- une sortie (25) de commande de test d'une chaine de traitement de protection différentielle (2B) pour commander la circulation d'un courant différentiel (IDT) de test entre l'amont et l'aval d'un transformateur (20) de mesure de courant différentiel (ID), et
- des modules (60-64) de détermination de l'état du test de la protection différentielle,
des modules de détermination de l'état global du test indiquent un test négatif si le test de la protection différentielle est en défaut ou si les modules de détermination de l'état du test de la protection arc électrique indiquent un test négatif.

14. Dispositif de test selon l'une quelconque des revendications 9 à 13 **caractérisé en ce que** l'unité de traitement (12) commande les tests de protection arc électrique et les tests de protection différentielle de manière automatique à intervalles de temps prédéterminés.

15. Dispositif de test selon l'une quelconque des revendications 9 à 14 **caractérisé en ce que** l'unité de traitement (12) comporte une entrée connectée à un élément (27) de commande de test pour commander le test de manière manuelle, la durée d'injection de signaux de test étant supérieure à des temps de déclenchement (TD, TD2).

16. Dispositif de test selon l'une quelconque des revendications 9 à 15 **caractérisé en ce que** l'unité de traitement comporte une sortie (D) de déclenchement de l'ouverture d'un appareil électrique (1) si le test de la protection différentielle est en défaut ou si l'état du test de la protection arc électrique indique un test négatif, ou si l'élément (27) de test commande le test de manière manuelle.

17. Appareil de protection électrique comportant des contacts principaux (3), un capteur (4) de courant sur au moins une ligne (5), un mécanisme (6) d'ouverture desdits contacts principaux (3), et un dispositif de protection d'arc électrique connecté au capteur de courant comportant un dispositif de test dudit dispositif de protection d'arcs électriques selon l'une des revendications 9 à 16,
le capteur de courant est un transformateur comportant au moins un premier enroulement de mesure (15) et un deuxième enroulement de test (14), ledit dispositif de test dudit dispositif de protection d'arcs électriques étant connecté audit enroulement de test (14) pour injecter des signaux de test (SF1, SF2, SF3), et
le dispositif de test comporte des modules de traitements dans une unité de traitement (12) pour traiter des signaux de test (SF1, SF2, SF3).

## Patentansprüche

1. Verfahren zum Testen einer Schutzvorrichtung gegen Lichtbögen, wobei die Schutzvorrichtung gegen Lichtbögen eine Messkette aufweist, wobei die Messkette eine erste Messwicklung (15) eines Strommesstransformators (4) aufweist, wobei das Testverfahren eine Testphase des Lichtbogenschutzes mit Schritten der Einspeisung eines Testsignals in die Verarbeitung von Lichtbogensignalen und Verarbeitungsschritte des Testsignals aufweist,
das aufweist:
- mindestens einen Schritt der Einspeisung mindestens eines Testsignals (SF1, SF2, SF3) auf mindestens einer Frequenz (F1, F2, F3) in eine zweite Testwicklung (14) des Strommesstransformators (4) während mindestens einer vorbestimmten Dauer (T1, T2, T3), wobei eine Gesamttestdauer, die mindestens die vorbestimmte Dauer (T1, T2, T3) enthält, kürzer ist als eine Nichtauslösezeit (TND)
- mindestens einen Kontrollschritt (52, 53, 54, 71, 74, 77), um während der Einspeisung des mindestens einen Signals (SF1, SF2, SF3) mindestens ein gefiltertes und von der Messkette verarbeitetes Testsignal und/oder Schutzfunktionen zu kontrollieren, und
- einen Schritt (55) der Bestimmung des Zustands des Tests des Lichtbogenschutzes, wobei der Zustand des Tests des Lichtbogenschutzes negativ ist, wenn kein Testsignal korrekt von der Messkette verarbeitet wird.

2. Testverfahren nach Anspruch 1, **dadurch gekennzeichnet, dass** es während der Testphase aufweist:
- einen ersten Schritt (52, 73) der Einspeisung eines ersten Testsignals (SF1) auf einer ersten Frequenz (F1) während einer ersten vorbestimmten Dauer (T1) in die zweite Testwicklung (14) des Strommesstransformators (4),
- einen zweiten Schritt (53, 76) der Einspeisung eines zweiten Testsignals (SF2) auf einer zweiten Frequenz (F2) während einer zweiten vorbestimmten Dauer (T2) in die zweite Testwicklung (14) des Strommesstransformators (4), wobei eine Gesamttestdauer, die mindestens die erste und die zweite Dauer (T1 und T2) enthält, kürzer ist als eine Nichtauslösezeit (TND),
- Kontrollschritte (52, 53, 54, 71, 74, 77), um während der Einspeisungen des ersten und des zweiten Testsignals (SF1, SF2,) gefilterte und von einer Messkette verarbeitete Testsignale und/oder Schutzfunktionen zu kontrollieren, und
- den Schritt (55) der Bestimmung des Zustands des Tests des Lichtbogenschutzes, wobei der Zustand des Tests des Lichtbogenschutzes negativ ist, wenn kein Testsignal korrekt von der Messkette verarbeitet wurde.

3. Testverfahren nach Anspruch 2, **dadurch gekennzeichnet, dass** es während der Testphase aufweist:
- einen dritten Schritt (54, 79) der Einspeisung eines dritten Testsignals (SF3) auf einer dritten Frequenz (F3) während einer dritten vorbestimmten Dauer (T3) in die zweite Testwicklung (14) des Strommesstransformators (4), wobei die Gesamttestdauer, die mindestens die erste, zweite und dritte Dauer (T1, T2 und T3) enthält, kürzer ist als eine Nichtauslösezeit (TND),
- Kontrollschritte (52, 53, 54, 74, 77, 80), um während der Einspeisungen des ersten, zweiten und dritten Testsignals (SF1, SF2, SF3) gefilterte und von einer Messkette verarbeitete Testsignale und/oder Schutzfunktionen zu kontrollieren, und
- den Schritt der Bestimmung (55, 82) des Zustands des Tests des Lichtbogenschutzes, wobei der Zustand des Tests des Lichtbogenschutzes negativ ist, wenn kein Testsignal korrekt von der Messkette verarbeitet wird.

4. Testverfahren nach einem der Ansprüche 2 oder 3, **dadurch gekennzeichnet, dass** es einen Kontrollschritt (51 und 71) während der Testphase aufweist, um das Vorhandensein eines Leitungssignals (I Leitung) zu kontrollieren,
wobei der Schritt der Bestimmung des Zustands des Tests des Lichtbogenschutzes einen negativen Test anzeigt:
- wenn kein Testsignal korrekt von der Messkette verarbeitet wird, oder
- wenn nur ein Testsignal korrekt von der Messkette verarbeitet wird und und das Leitungssignal unter einer vorbestimmten Schwelle liegt.

5. Testverfahren nach einem der Ansprüche 1 bis 4, **dadurch gekennzeichnet, dass** die Testphase einen Testschritt (60-64) einer Differentialschutz-Verarbeitungskette aufweist, indem das Fließen eines Differentialstroms (IDT) zwischen der stromaufwärtigen und der stromabwärtigen Seite eines Differentialstrom (ID)-Messtransformators (20) gesteuert wird,
ein gemeinsamer Schritt der Bestimmung (55, 82, 62) des Zustands des Tests einen negativen Test anzeigt, wenn der Testschritt des Differentialschutzes (60-64) ausgefallen ist, oder wenn der Schritt der Bestimmung des Zustands des Tests des Lichtbogenschutzes einen negativen Test anzeigt.

6. Testverfahren nach einem der Ansprüche 1 bis 5, **dadurch gekennzeichnet, dass** die Testphase automatisch in vorbestimmten Zeitintervallen ausgelöst wird.

7. Testverfahren nach einem der Ansprüche 1 bis 6, **dadurch gekennzeichnet, dass** die Testphase manuell mittels eines Teststeuerelements ausgelöst wird, wobei die Dauer (TM) der Einspeisung von Testsignalen länger ist als Auslösezeiten (TD).

8. Testverfahren nach einem der Ansprüche 1 bis 7, **dadurch gekennzeichnet, dass** die Testphase einen Schritt des Auslösens der Öffnung eines elektrischen Geräts aufweist, wenn der Testschritt des Differentialschutzes ausgefallen ist, wenn der Schritt der Bestimmung des Zustands des Tests des Lichtbogenschutzes einen negativen Test anzeigt oder wenn die Testphase manuell ausgelöst wird.

9. Testvorrichtung (2) einer Schutzvorrichtung gegen Lichtbögen, wobei die Schutzvorrichtung gegen Lichtbögen eine Messkette aufweist, wobei die Messkette eine erste Messwicklung (15) eines Strommesstransformators (4) aufweist, wobei die Testvorrichtung (2) eine Schaltung zur Einspeisung eines Signals in die Verarbeitung von Lichtbogensignalen und eine Verarbeitungseinheit (12) aufweist, um Messsignale und das Testsignal zu verarbeiten,
die aufweist:
- einen Generator, um mindestens ein Testsignal (SF1, SF2, SF3) auf mindestens einer Frequenz (F1, F2, F3) zu erzeugen, wobei das mindestens eine Testsignal dazu bestimmt ist, während mindestens einer vorbestimmten Dauer (T1, T2, T3) in eine zweite Testwicklung (14) des Strommesstransformators (4) eingespeist zu werden, wobei eine Gesamttestdauer, die mindestens die vorbestimmte Dauer (T1, T2, T3) enthält, kürzer ist als eine Nichtauslösezeit (TND), und
- mindestens ein Bandpassfilter (11F1, 11F2, 11F3), das Messsignale auf der mindestens einen Frequenz (F1, F2, F3) durchlässt, das einen Eingang für den Empfang eines von der Messwicklung (15) des Messtransformators (4) gelieferten Messsignals (Im) und einen mit der Verarbeitungseinheit verbundenen Ausgang hat,
wobei die Verarbeitungseinheit aufweist:
- mit dem mindestens einen Filter verbundene Eingänge, um während der Einspeisung des mindestens einen Testsignals (SF1, SF2, SF3) mindestens ein Signal am Ausgang des mindestens einen Filters (11F1, 11F2, 11F3) zu erkennen und zu verarbeiten, und
- Module zur Bestimmung des Zustands des Tests des Lichtbogenschutzes, wobei der Zustand des Tests des Lichtbogenschutzes negativ ist, wenn kein Testsignal (SF1, SF2, SF3) korrekt von der Messkette verarbeitet wird.

10. Testvorrichtung nach Anspruch 9, **dadurch gekennzeichnet, dass**:
- der Generator (13) erzeugt:
- ein erstes Testsignal (SF1) auf einer ersten Frequenz (F1), wobei das erste Testsignal dazu bestimmt ist, während einer ersten vorbestimmten Dauer (T1) in die zweite Testwicklung (14) eines Strommesstransformators (4) eingespeist zu werden, und
- ein zweites Testsignal (SF2) auf einer zweiten Frequenz (F2), wobei das zweite Signal dazu bestimmt ist, während einer zweiten vorbestimmten Dauer (T2) in die zweite Testwicklung (14) des Strommesstransformators (4) eingespeist zu werden, wobei eine Gesamttestdauer, die mindestens die erste und die zweite Dauer (T1 und T2) enthält, kürzer ist als eine Nichtauslösezeit (TND), und
- das mindestens eine Filter aufweist:
- ein erstes Bandpassfilter (11F1), das Messsignale auf der ersten Frequenz (F1) durchlässt, das einen Eingang zum Empfang eines von der ersten Messwicklung (15) des Messtransformators (4) gelieferten Messsignals (Im) und einen mit der Verarbeitungseinheit verbundenen Ausgang hat, und
- ein zweites Bandpassfilter (11F2), das Messsignale auf der zweiten Frequenz (F2) durchlässt, das einen Eingang zum Empfang des von der ersten Messwicklung (15) des Messtransformators (4) gelieferten Messsignals (Im) und einen mit der Verarbeitungseinheit verbundenen Ausgang hat,
wobei die Verarbeitungseinheit aufweist:
- mit den ersten und zweiten Filtern verbundene Eingänge, um während der Einspeisungen des ersten und des zweiten Testsignals (SF1, SF2) die Signale am Ausgang der Filter (11F1, 11F2) zu erkennen und zu verarbeiten, und
- Module zur Bestimmung des Zustands des Tests des Lichtbogenschutzes, wobei der Zustand des Tests des Lichtbogenschutzes negativ ist, wenn kein Testsignal (SF1, SF2) korrekt von der Messkette verarbeitet wird.

11. Testvorrichtung nach Anspruch 10, **dadurch gekennzeichnet:**
- **dass** der Generator (13) ein drittes Testsignal (SF3) auf einer dritten Frequenz (F3) erzeugt, wobei das dritte Testsignal dazu bestimmt ist, während einer dritten vorbestimmten Dauer (T3) in die zweite Testwicklung (14) des Strommesstransformators (4) eingespeist zu werden, wobei eine Gesamttestdauer, die mindestens die erste, zweite und dritte Dauer (T1, T2 und T3) enthält, kürzer ist als eine Auslösezeit (TND), und
- **dass** sie ein drittes Bandpassfilter (11F3) aufweist, das Messsignale auf der dritten Frequenz (F3) durchlässt, das einen Eingang für den Empfang eines von der ersten Messwicklung (15) des Messtransformators (4) gelieferten Messsignals (Im) und einen mit der Verarbeitungseinheit verbundenen Ausgang hat,
wobei die Verarbeitungseinheit aufweist:
- mit den ersten, zweiten und dritten Filtern (11F1, 11F2, 11F3) verbundene Eingänge, um während der Einspeisungen des ersten, zweiten und dritten Testsignals (SF1, SF2, SF3) die von den Filtern gelieferten Signale zu erkennen und zu verarbeiten, und
- Module zur Bestimmung des Zustands des Tests des Lichtbogenschutzes, wobei der Zustand des Tests des Lichtbogenschutzes negativ ist, wenn kein Testsignal korrekt von der Messkette verarbeitet wird.

12. Testvorrichtung nach einem der Ansprüche 9 bis 11, **dadurch gekennzeichnet, dass** die Verarbeitungseinheit auch aufweist:
- einen Leitungseingang, um während der Einspeisungen des mindestens einen Testsignals (SF1, SF2, SF3) die vom mindestens einen Filter (11F1, 11F2, 11F3) gelieferten Signale und ein Leitungssignal (Im, 10) zu erkennen und zu verarbeiten, und
- Module zur Bestimmung des Zustands des Tests des Lichtbogenschutzes, wobei der Zustand des Tests des Lichtbogenschutzes negativ ist, wenn kein Testsignal korrekt von der Messkette verarbeitet wird, oder wenn ein einziges Testsignal von dreien korrekt von der Messkette verarbeitet wird und wenn das Leitungssignal unter einer vorbestimmten Schwelle liegt

13. Testvorrichtung nach einem der Ansprüche 9 bis 12, **dadurch gekennzeichnet, dass** die Verarbeitungseinheit aufweist (12):
- einen Teststeuerausgang (25) einer Differentialschutz-Verarbeitungskette (2B), um das Fließen eines Test-Differentialstroms (IDT) zwischen der stromaufwärtigen und der stromabwärtigen Seite eines Differentialstrom (ID)-Messtransformators (20) zu steuern, und
- Module (60-64) zur Bestimmung des Zustands des Tests des Differentialschutzes, wobei Module zur Bestimmung des Gesamtzustands des Tests einen negativen Test anzeigen, wenn der Test des Differentialschutzes ausgefallen ist oder wenn die Module zur Bestimmung des Zustands des Tests des Lichtbogenschutzes einen negativen Test anzeigen.

14. Testvorrichtung nach einem der Ansprüche 9 bis 13, **dadurch gekennzeichnet, dass** die Verarbeitungseinheit (12) die Lichtbogenschutztests und die Differentialschutztests automatisch in vorbestimmten Zeitintervallen steuert.

15. Testvorrichtung nach einem der Ansprüche 9 bis 14, **dadurch gekennzeichnet, dass** die Verarbeitungseinheit (12) einen mit einem Teststeuerelement (27) verbundenen Eingang aufweist, um den Test manuell zu steuern, wobei die Dauer der Einspeisung von Testsignalen länger ist als Auslösezeiten (TD, TD2).

16. Testvorrichtung nach einem der Ansprüche 9 bis 15, **dadurch gekennzeichnet, dass** die Verarbeitungseinheit einen Auslöseausgang (D) der Öffnung eines elektrischen Geräts (1) aufweist, wenn der Test des Differentialschutzes ausgefallen ist oder wenn der Zustand des Tests des Lichtbogenschutzes einen negativen Test anzeigt oder wenn das Testelement (27) den Test manuell steuert.

17. Elektrisches Schutzgerät, das Hauptkontakte (3), einen Stromsensor (4) auf mindestens einer Leitung (5), einen Öffnungsmechanismus (6) der Hauptkontakte (3) und eine mit dem Stromsensor verbundene Lichtbogenschutzvorrichtung aufweist, das eine Testvorrichtung der Lichtbogenschutzvorrichtung nach einem der Ansprüche 9 bis 16 aufweist,
wobei der Stromsensor ein Transformator ist, der mindestens eine erste Messwicklung (15) und eine zweite Testwicklung (14) aufweist, wobei die Testvorrichtung der Lichtbogenschutzvorrichtung mit der Testwicklung (14) verbunden ist, um Testsignale (SF1, SF2, SF3) einzuspeisen, und
die Testvorrichtung Verarbeitungsmodule in einer Verarbeitungseinheit (12) aufweist, um Testsignale (SF1, SF2, SF3) zu verarbeiten.

## Claims

1. Method for testing an electric-arc protection device, the electric-arc protection device comprising a measurement chain, the measurement chain comprising a first winding (15) for measuring of a current-measurement transformer (4), the method for testing comprising a phase of testing the electric-arc protection with steps of injecting a test signal into the electric-arc signal processing and steps of processing said test signal,
comprising:
- at least one step of injecting at least one test signal (SF1, SF2, SF3) at at least one frequency (F1, F2, F3) into a second winding (14) for testing of the current-measurement transformer (4) during at least one preset duration (T1, T2, T3), a total test duration comprising at least the preset duration (T1, T2, T3) being shorter than a no-trigger time (TND),
- at least one monitoring step (52, 53, 54, 71, 74, 77) in order to monitor, during the injection of said at least one signal (SF1, SF2, SF3), at least one test signal filtered and processed by the measurement chain and/or protection functions, and
- a step (55) of determining the state of the test of the electric-arc protection, the state of the test of the electric-arc protection being negative is no test signal is correctly processed by the measurement chain.

2. Test method according to Claim 1, **characterized in that** it comprises, during the test phase:
- a first step (52, 73) of injecting a first test signal (SF1) at a first frequency (F1) into the second winding (14) for testing of the current-measurement transformer (4) during a first preset duration (T1),
- a second step (53, 76) of injecting a second test signal (SF2) at a second frequency (F2) into said second winding (14) for testing of said current-measurement transformer (4) during a second preset duration (T2), a total test duration comprising at least the first and the second duration (T1 and T2) being shorter than a no-trigger time (TND),
- monitoring steps (52, 53, 54, 71, 74, 77) in order to monitor during the injections of the first and second test signal (SF1, SF2) test signals filtered and processed by a measurement chain and/or protection functions, and
- said step (55) of determining the state of the test of the electric-arc protection, the state of the test of the electric-arc protection being negative if no test signal is correctly processed by the measurement chain.

3. Test method according to Claim 2, **characterized in that** it comprises, during the test phase:
- a third step (54, 79) of injecting a third test signal (SF3) at a third frequency (F3) into said second winding (14) for testing of said current-measurement transformer (4) during a third preset duration (T3), the total test duration, comprising at least the first, the second and the third durations (T1, T2 and T3) being shorter than a no-trigger time (TND),
- monitoring steps (52, 53, 54, 74, 77, 80) in order to monitor during the injections of the first, second and third test signal (SF1, SF2, SF3) test signals filtered and processed by a measurement chain and/or protection functions, and
- said step (55, 82) of determining the state of the test of the electric-arc protection, the state of the test of the electric-arc protection being negative if no test signal is correctly processed by the measurement chain.

4. Test method according to either of Claims 2 and 3, **characterized in that** it comprises a monitoring step (51 and 71) during said test phase in order to monitor the presence of a line signal (I line), and
said step of determining the state of the test of the electric-arc protection indicates a negative test:
- if no test signal is correctly processed by the measurement chain, or
- if a single test signal is correctly processed by the measurement chain and said line signal is lower than a preset threshold.

5. Test method according to any one of Claims 1 to 4, **characterized in that** the test phase comprises a step (60-64) of testing a differential-protection processing chain by commanding the flow of a differential current (IDT) between the upstream and the downstream of a transformer (20) for measuring differential current (ID), and
a step (55, 82, 62) of determining the state of the common test indicates a negative test if the step of testing the differential protection (60-64) is failed, or said step of determining the state of the test of the electric-arc protection indicates a negative test.

6. Test method according to any one of Claims 1 to 5, **characterized in that** the test phase is triggered automatically at preset time intervals.

7. Test method according to any one of Claims 1 to 6, **characterized in that** the test phase is triggered manually by means of a test command element, the duration (TM) of injection of test signals being longer than trigger times (TD).

8. Test method according to any one of Claims 1 to 7, **characterized in that** the test phase comprises a step of triggering an electrical unit to open if the step of testing differential protection is failed, if said step of determining the state of the test of the electric-arc protection indicates a negative test or if the test phase is triggered manually.

9. Device (2) for testing an electric-arc protection device, the electric-arc protection device comprising a measurement chain, the measurement chain comprising a first winding (15) for measuring of a current-measurement transformer (4), the device for testing comprising a circuit for injecting a signal into the electric-arc signal processing and a processing unit (12) in order to process measurement signals and said test signal,
comprising:
- a generator in order to generate at least one test signal (SF1, SF2, SF3) at at least one frequency (F1, F2, F3), said at least one test signal being intended to be injected into a second winding (14) for testing of the current-measurement transformer (4) during at least one preset duration (T1, T2, T3), a total test duration comprising at least the preset duration (T1, T2, T3) being shorter than a no-trigger time (TND), and
- at least one passband filter (11F1, 11F2, 11F3) that lets pass measurement signals at said at least one frequency (F1, F2, F3), and that has an input in order to receive a measurement signal (Im) delivered by a the first winding (15) for measuring of the measurement transformer (4) and an output connected to the processing unit,
the processing unit comprising:
- inputs connected to said at least one filter in order to detect and process during the injection of said at least one test signal (SF1, SF2, SF3) at least one signal output from said at least one filter (11F 1, 11F2, 11F3), and
- modules for determining the state of the test of the electric-arc protection, the state of the test of the electric-arc protection being negative if no test signal (SF1, SF2, SF3) is correctly processed by the measurement chain.

10. Test device according to Claim 9, **characterized in that**:
- said generator (13) generates:
- a first test signal (SF1) at a first frequency (F1), said first test signal being intended to be injected into the second winding (14) for testing of a current-measurement transformer (4) during a first preset duration (T1), and
- a second test signal (SF2) at a second frequency (F2), said second test signal being intended to be injected into said second winding (14) for testing of said current-measurement transformer (4) during a second preset duration (T2), a total test duration comprising at least the first and the second duration (T1 and T2) being shorter than a no-trigger time (TND), and
- the at least one filter comprises:
- a first passband filter (11F 1) that lets pass measurement signals at said first frequency (F1), and that has an input in order to receive a measurement signal (Im) delivered by the first winding (15) of measuring of the current-measurement transformer (4) and an output connected to the processing unit, and
- a second passband filter (11F2) that lets pass measurement signals at said second frequency (F2), and that has an input in order to receive said measurement signal (Im) delivered by said first winding (15) of measuring of the measurement transformer (4) and an output connected to the processing unit,
the processing unit comprising:
- inputs connected to said first and second filters in order to detect and process during the injections of the first and the second test signal (SF1, SF2) the signals output from said filters (11F1, 11F2), and
- modules for determining the state of the test of the electric-arc protection, the state of the test of the electric-arc protection being negative if no test signal (SF1, SF2) is correctly processed by the measurement chain.

11. Test device according to Claim 10, **characterized:**
- **in that** said generator (13) generates a third test signal (SF3) at a third frequency (F3), said third test signal being intended to be injected into said second winding (14) of testing of said current-measurement transformer (4) during a third preset duration (T3), a total test duration comprising at least the first, the second and the third durations (T1, T2 and T3) being shorter than a no-trigger time (TND), and
- **in that** it comprises a third passband filter (11F3) that lets pass measurement signals at the third frequency (F3), and that has an input in order to receive a measurement signal (Im) delivered by said first winding (15) of measuring of the current-measurement transformer (4) and an output connected to the processing unit, the processing unit comprising:
- inputs connected to said first, second and third filters (11F1, 11F2, 11F3) in order to detect and process during the injections of the first, the second and the third test signal (SF1, SF2, SF3), the signals delivered by the filters, and
- modules for determining the state of the test of the electric-arc protection, the state of the test of the electric-arc protection being negative if no test signal is correctly processed by the measurement chain.

12. Test device according to any one of Claims 9 to 11, **characterized in that** the processing unit also comprises:
- a line input in order to detect and process during the injections of the at least one test signal (SF1, SF2, SF3), the signals delivered by said at least one filter (11F1, 11F2, 11F3) and a line signal (Im, 10), and
- modules for determining the state of the test of the electric-arc protection, the state of the test of the electric-arc protection being negative if no test signal is correctly processed by the measurement chain, or if a single test signal among three is correctly processed by the measurement chain and said line signal is lower than a preset threshold.

13. Test device according to any one of Claims 9 to 12, **characterized in that** the processing unit comprises (12):
- an output (25) for commanding the test of a differential-protection processing chain (2B), in order to command the flow of a differential test current (IDT) between the upstream and the downstream of a transformer (20) for measuring differential current (ID), and
- modules (60-64) for determining the state of the test of the differential protection, and modules for determining the overall state of the test indicate a negative test if the test of the differential protection is failed or if the modules for determining the state of the test of the electric-protection indicate a negative test.

14. Test device according to any one of Claims 9 to 13, **characterized in that** the processing unit (12) commands the electric-arc protection tests and the differential projection tests automatically at preset time intervals

15. Test device according to any one of Claims 9 to 14, **characterized in that** the processing unit (12) comprises an input that is connected to a test-command element (27) in order to command the test manually, the duration of injection of test signals being longer than triggering times (TD, TD2).

16. Test device according to any one of Claims 9 to 15, **characterized in that** the processing unit comprises an output (D) for triggering an electrical unit (1) to open if the test of the differential protection is failed or if the state of the test of the electric-arc protection indicates a negative test, or if the test-command element (27) commands the test manually.

17. Electric protection unit comprising main contacts (3), a sensor (4) of current on at least one line (5), a mechanism (6) for opening said main contacts (3), and an electric-arc protection device connected to the sensor of current
comprising:
- a device for testing said electric-arc protection device according to one of Claims 9 to 16,
- the sensor of current is a transformer comprising at least one first winding (15) of measuring and a second winding (14) of testing, said device for testing said electric-arc protection device being connected to said test winding (14) in order to inject test signals (SF1, SF2, SF3), and
- the test device comprises processing modules in a processing unit (12) in order to process the test signals (SF1, SF2, SF3).
